# EUROPEAN PATENT APPLICATION

(11) **EP 0 998 181 A2**
(43) Date of publication of application: **03.05.2000**
(21) Application number: 99660165.4
(22) Date of filing: 25.10.1999
(51) Int. Cl.: H05K 7/20, H01L 23/473

(54) **Assembly and method for cooling an electronic component or module with a liquid**

(30) Priority: 27.10.1998 FI 982334
(71) Applicant: ABB Industry Oy,, 00381 Helsinki (FI)
(72) Inventor: Laurila, Risto, 02620 Espoo (FI)
(74) Representative: Hovi, Simo

(57) **Abstract**

The invention relates to an assembly and method for cooling at least one electronic component or module (1) with a cooling liquid, said assembly having the flow channel part (2) of the cooling element comprised of at least two thin, thermally conductive plates, between which plates the flow channels (6) are arranged so that the surface of the flow channel part (2), which is placed against bottom surface of the component or module (1) to be cooled, conforms essentially to the bottom shape of the component or module (1) to be cooled. The flow channel part (2) is fastened against the surface of said component or module (1) to be cooled by means of at least one compressive part (3).

## Description

The present invention relates to an assembly according to the preamble of claim 1 for cooling an electronic component or module with a liquid and a method according to the preamble of claim 8 for cooling an electronic component or module with a liquid.

A great number of methods are known in the prior art for removing the heat dissipated in electronic components and modules, said methods being based on transferring the dissipated heat to a cooling element attached to said component and containing flow channels, whereby the heat can be further removed from said cooling element by means of a cooling liquid flowing in said flow channels. In these embodiments, the heat is transferred from the component to be cooled by conduction to the surface of the coolant flow channel of the cooling element. There, transfer of heat from the surface of the flow channel to the cooling medium principally takes place by convection. To assure efficient cooling, the path of heat conduction from the component to be cooled to the surface of the coolant flow channel in the cooling element should be as short as possible and the area of the heat transfer surfaces should be maximized. Moreover, the internal thermal resistance should be minimized in both the cooling element and the joint between the cooling element and the component to be cooled. In addition to the desired thermal qualities, the cooling element must be made sufficiently rigid to prevent excessive stress from being imposed on the components mounted thereon. If the cooling element is also used as a current busbar for the components to be cooled, the element respectively must be made conductive. Obviously, the cooling element must also have a design that is advantageous by its mounting features and manufacturing cost.

In prior-art embodiments in which the cooling element is made by extrusion or casting from aluminium or other metal of high thermal conductivity, the poor thermal performance of such cooling elements have hampered their use. The fabrication of small-diameter, thin-walled coolant flow channels has been problematic in extruded and cast cooling elements, whereby the small overall heat transfer area of the coolant flow channels and the long path of thermal conduction from the component to be cooled to the coolant flow channels degrade the heat transfer capacity of the cooling element. Hence, a number of new openings must be drilled in the cooling element to control the flow of the cooling medium and to add new passageways between the coolant flow channels, however, necessitating at least a portion of the openings to be closed in the final assembly of the element, which increases the production costs of the cooling element. Moreover, the thermal contact between the component to be cooled and the cooling element made by casting or extruding is inferior due to the excessive elasticity of the cooling element and the unevenness of its surface, which may degrade the heat transfer capacity of the element and cause damage to the component mounted thereon.
Furthermore, certain metals such as aluminium must be alloyed for fabrication, which may reduce their thermal conductivity as compared to that of an unalloyed metal.

Cooling element embodiments manufactured from two plates by welding them together, whereby at least one of the plates must be moulded prior to welding so as to provide passageways to the flow of the cooling liquid, are plagued by leaks of the cooling liquid via the welds. Also the mounting of the component to be cooled onto the welded cooling element by screws, for example, may cause leaks of the cooling liquid if the liquid can pass via the screw joints to the exterior side of the cooling element. Furthermore, the fabrication of a cooling element by welding is generally rather expensive.

It is an object of the present invention to provide a novel type of assembly and method capable of overcoming the above-described problems.

The goal of the invention is achieved by virtue of making the cooling element from two parts of which the first one has coolant flow channels made thereto. Respectively, the second part of the cooling element such as a bar or plate, which can be made, e.g., from aluminium, acts as a mounting part by means of which the first part of the cooling element containing the coolant flow channels is compressed firmly against the component to be cooled. The part containing the coolant flow channels is comprised of at least two thin plates which are tightly bonded together leaving the coolant flow channels between the plates so that the surface of the cooling element part intended to meet the component to be cooled is designed to conform to the surface shape of the component to be cooled. The plates can be bonded to each other, e.g., by compression welding or brazing, after which the coolant flow channels are formed in nonbonded areas between the plates with the help of pneumatic or hydraulic pressure that forces the plates to expand against a mould placed adjcent to both sides of the bonded sheet metal plates.

More specifically, the assembly according to the invention is characterized by what is stated in the characterizing part of claim 1.

Furthermore, the method according to the invention is characterized by what is stated in the characterizing part of claim 8.

The invention offers significant benefits.

The cooling element can be provided with a plurality of small-diameter, thin-walled coolant flow channels, whereby the heat transfer area from the flow channel walls to the cooling liquid becomes substantially large. Moreover, the turbulence of the coolant flow in the small-diameter channels is increased, which further improves the convective heat transfer from the wall of the flow channel into the cooling liquid. Owing to the small thickness of the flow channel walls, the component or module to be cooled can be placed close to the flow channels, whereby the path of heat conduction from the component to the surface of the channels remains short. The dimensions and placement of the coolant flow channels in the flow channel part of the cooling element can be selected relatively freely according to the heat transfer requirements. Leaks of the cooling liquid remain minimal, because the flow channel part is substantially free from conventional welded or brazed bonds. Also the component to be cooled can be mounted on the cooling element, e.g., with screws without a risk of coolant leaks, because the plates of the flow channel part are bonded together in a sealed manner, whereby the coolant cannot leak out from the flow channels via the seam between the plates. The compressive part serving to hold the component to be cooled against the coolant flow channel part stiffens the overall structure of the cooling element thus reducing the stress imposed on the component by the mechanical bending of the cooling element. The cooling element according to the invention has a low weight and small size in regard to the heat transfer capacity and is also cost-effective to manufacture and install.

In the following the invention will be examined in greater detail with reference to exemplifying embodiments illustrated in the appended drawings.

Fig. 1 is a bottom view of a cooling element according to the invention as seen from side of its compressive part.

Fig. 2 is a top view of the cooling element according to the invention as seen from side of the component to be cooled.

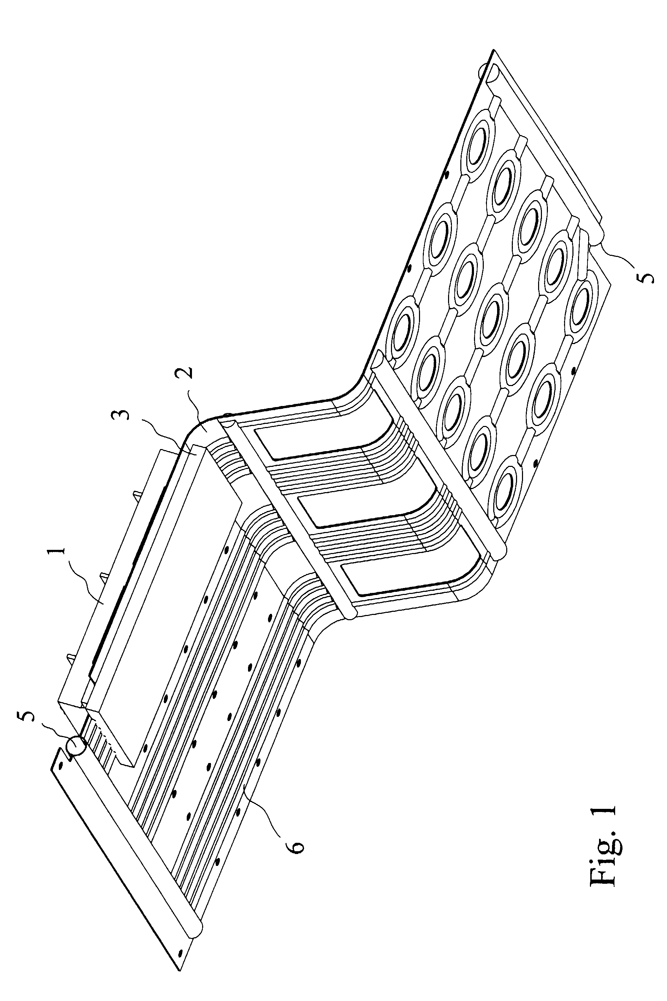

Referring to Fig. 1, therein is shown a cooling element having its flow channel part 2 made from two thin plates of a material having a high thermal conductivity that are bonded together. When aluminium, for instance, is used as the material of the plates, the sheet thickness is selected to be about 3 - 4 mm. The flow channel part 2 of the cooling element can be fabricated using, e.g., a technique in which the desired pattern of the flow channels 6 is painted with graphite onto one of the plates, whereafter the other plate is placed on the first one painted with the graphite pattern. Then, the plates can be bonded to each other using, e.g., a cold-rolling technique, whereby the plates undergo metallurgical diffusion-weld bonding with each other so as to form a solid object for all other areas except the pattern of the flow channels 6 painted with graphite. Next, the bonded plates can be enclosed from both sides by inserting the object in a mould against which the flow channels 6 are formed in the interior of the bonded plates by means of hydraulic or pneumatic expansion moulding. This type of manufacturing technique is conventionally used in applications in which the structure is required to exhibit perfect tightness as is the case with the evaporator units of refrigerators. However, the dimensional accuracy of the cold-rolling technique remains wanting in the cold-rolling direction of the element and, therefore, the design of the element structure needs great care in regard to dimensional tolerances.

Alternatively, the flow channel part 2 can be made from two thin plates of high thermal conductivity by first inserting a thin sheet of brazing alloy between the plates. Next, the plates are set under compression and heated in a mould enclosing the plates from both sides. After the brazing alloy has melted, the flow channels 6 are opened between the plates against the enclosing mould using hydraulic or pneumatic pressure. When solidified, alloy brazing the seams of the moulded plates assure leak-tight adherence of the plates against each other. The dimensional accuracy of a flow channel structure made by this technique falls within very tight tolerances.

The flow channel 6 thus formed may have its width, height, direction and interchannel distance selected relatively independently from the other flow channels 6 so as to satisfy the heat transfer requirements. For example, the smallest height of a flow channel 6 may be only a few millimeters, while the height can be increased as necessary up to 10 mm, e.g., at the coolant inlet/outlet connections 5. Furthermore, the wall thickness of the flow channels 6 can be made as thin as about 0.5 - 1.0 mm, whereby the conduction path of heat from the component 1 to be cooled to the inner surfaces of the flow channels 6 becomes very short. As the flow channels 6 are opened by expanding them against a mould having a shape identical to that of the bottom of the component 1 to be cooled, the surfaces of the flow channel part 2 and the component 1 to be cooled mate perfectly with each other. For example, if the surface of the component 1 to be cooled facing the flow channel part 2 of the cooling element is flat, the flow channels 6 are expansion moulded toward that side of the flow channel part 2 which will face the compressive part 3 of the cooling element, whereby said surface of the flow channel part 2 intended to rest against the component 1 to be cooled remains planar, respectively. Thus, a good thermal contact and a low thermal resistance will be achieved between the cooling element and the component to be cooled. The thermal resistance in the joint between the component 1 to be cooled and the flow channel part 2 of the cooling element can be reduced by applying a thermally conducting compound into the joint. The cooling liquid connections 5 can be attached to the flow channel part 2 for instance by welding or brazing.

Respectively, the compressive part 3 is contoured with recesses adapted to mate with the projections of the flow channel part 2, whereby the areas of the compressive part 3 remaining between its recesses serve to compress the flow channel part 2 over its respective areas remaining between the flow channels 6 tightly against the component 1 to be cooled.

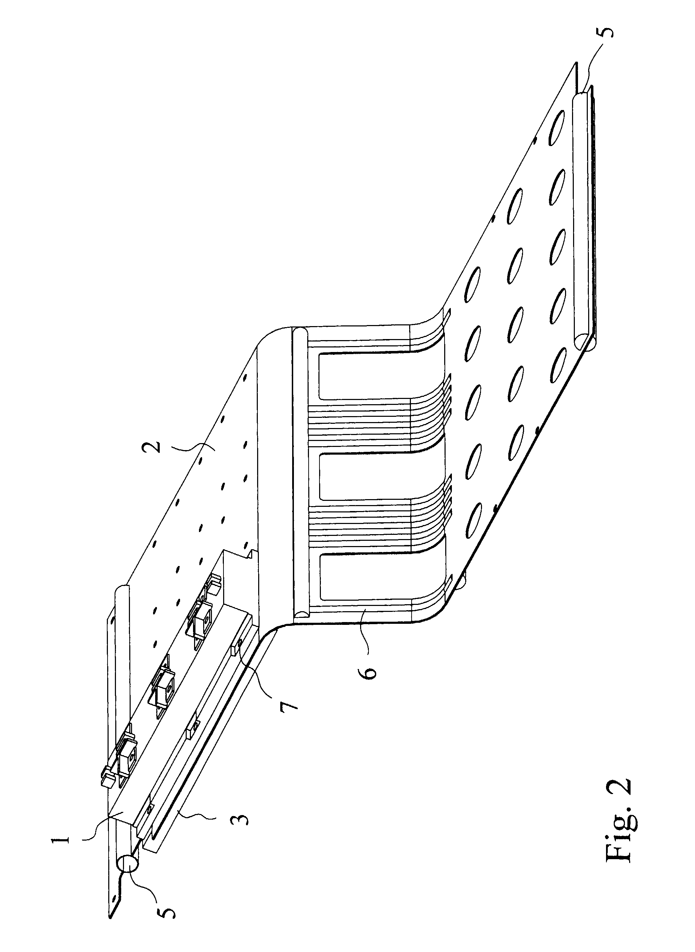

In Fig. 2 is shown an example of the placement of the flow channels 6 in the flow channel part 2. Herein, the flow channels 6 are expanded on that side of the flow channel part 2 which faces the compressive part 3, whereby the other surface of the flow channel part 2 to rest against the component 1 to be cooled stays planar during fabrication. The component 1 to be cooled is fastened with screws 7 to the flow channel part 2 and the compressive part 3, respectively.

In addition to those described above, the invention may have alternative embodiments.

For example, the flow channels 6 may also be adapted in superimposed layers if the flow channel part 2 is made from more than two sheet metal plates bonded together. Furthermore, the turbulence and convective heat transfer effect of the cooling liquid flow passing in the flow channels 6 can be improved by providing the channels with discontinuities such as constrictions, expansions or bends. The flow channel part 2 may also be formed into a nonplanar shape if so required by its target equipment design. Due to the small thickness of the walls in the flow channels 6, the liquid passing in the coolant flow channels 6 can be circulated at an elevated pressure level thus forcing the flow channel part 2 to conform tighter to the bottom shape of the component 1 to be cooled, whereby the thermal resistance in the joint between the flow channel part 2 and the component 1 to be cooled is further reduced and the heat transfer between said elements is improved. A single cooling channel part 2 may be designed to serve a plurality of components 1 to be cooled, whereby the components 1 to be cooled may also be placed on different sides of the flow channel part 2. When required, the compressive part 3 may be shaped convex or concave so as to function as a kind of spring that equalizes the profile of the surface pressure acting between the flow channel part 2 and the component 1 to be cooled. The cooling liquid connections 5 of the flow channel part 2 can be supported against the compressive part 3, thus making the connections 5 more resistant to forces and vibration imposed thereon during the installation and use of the cooling assembly.

## Claims

1. Assembly for cooling at least one electronic component or module (1) with a cooling liquid, said assembly comprising
- a flow channel part (2) including coolant flow channels (6), and
- connections (5) for passing said cooling liquid into the flow channels (6) and out from the flow channels (6),
**characterized** in that
- said flow channel part (2) is comprised of at least two thin, thermally conductive plates bonded to each other, between which plates the flow channels (6) are arranged so that the surface of the flow channel part (2), which is placed against bottom surface of the component or module (1) to be cooled, conforms essentially to the bottom shape of the component or module (1) to be cooled, and
- said assembly includes at least one compressive part (3) for fastening said flow channel part (2) against the surface of said component or module (1) to be cooled.

2. Assembly according to claim 1, **characterized** in that the surface of said flow channel part (2) placed against said component or module (1) to be cooled is essentially planar.

3. Assembly according to claim 1 or 2, **characterized** in that the surface of said compressive part (3) intended to mate with said flow channel part (2) conforms essentially to the corresponding surface of said flow channel part (2).

4. Assembly according to any of foregoing claims 1 - 3, **characterized** in that said flow channels (6) are provided with discontinuities for improving the turbulence of the cooling liquid flow.

5. Assembly according to any of foregoing claims 1 - 4, **characterized** in that the shape of said flow channel part (2) includes bends.

6. Assembly according to any of foregoing claims, **characterized** in that the cooling liquid connections (5) mounted on said flow channel part (2) are supported against said compressive part (3).

7. Assembly according to any of foregoing claims, **characterized** in that said compressive part (3) may have a concave or convex shape when so required.

8. Method for cooling at least one electronic component or module (1) with a cooling liquid, said method comprising the steps of
- passing said cooling liquid into a flow channel part (2) mounted between a compressive part (3) and at least one component or module (1) to be cooled via a connection (5) adapted to said flow channel part,
- circulating the cooling liquid in the flow channels (6) of said flow channel part (2), and
- passing the cooling liquid out from said flow channel part (2) via another connection (5),
**characterized** in that
- said flow channel part (2) is comprised of at least two thin, thermally conductive plates bonded to each other, between which plates the flow channels (6) are arranged so that the surface of the flow channel part (2), which is placed against bottom surface of the component or module (1) to be cooled, conforms essentially to the bottom shape of the component or module (1) to be cooled, and
- said flow channel part (2) is fastened against the surface of said component or module (1) to be cooled by means of at least one compressive part (3).

9. Method according to claim 8, **characterized** in that the cooling liquid circulated in said flow channels (6) is pressurized in order to increase the surface pressure acting between said component or module (1) to be cooled and said flow channel part (2).
